# EUROPÄISCHE PATENTSCHRIFT

(11) **EP 2 569 390 B1**
(45) Veröffentlichungstag und Bekanntmachung des Hinweises auf die Patenterteilung: **09.08.2017**
(21) Anmeldenummer: 11725356.7
(22) Anmeldetag: 10.05.2011
(51) Int. Cl.: C09K 5/14, H01L 23/373

(54) **VERFAHREN ZUR HERSTELLUNG EINER THERMISCH LEITFÄHIGEN ZUSAMMENSETZUNG AUF BASIS UMWELTFREUNDLICHER PFLANZLICHER UND/ODER TIERISCHER ÖLE ALS WÄRMELEITFÄHIGE MATERIALIEN**
PROCESS FOR THE PRODUCTION OF A THERMALLY CONDUCTIVE COMPOSITION BASED ON ECO-FRIENDLY VEGETABLE AND/OR ANIMAL OILS AS THERMALLY CONDUCTIVE MATERIALS
PROCEDE POUR LA PRODUCTION D'UNE COMPOSITION THERMOCONDUCTRICE À BASE D'HUILES VÉGÉTALES ET/OU ANIMALES RESPECTUEUSES DE L'ENVIRONNEMENT UTILISÉES COMME MATIÈRES THERMOCONDUCTRICES

(30) Priorität: 10.05.2010 DE 102010028800
(43) Veröffentlichungstag der Anmeldung: 20.03.2013
(73) Patentinhaber: Freie Universität Berlin, 14195 Berlin (DE)
(72) Erfinder: REICH, Stephanie, 10779 Berlin (DE); STRAßBURG, Thomas, 12247 Berlin (DE); DATSYUK, Vitaliy, 12249 Berlin (DE); ARNDT, Stephan, 14469 Potsdam (DE); FIRKOWSKA, Izabela, 10713 Berlin (DE); GHARAGOZLOO-HUBMANN, Katayoun, 14469 Potsdam (DE); LISUNOVA, Milana, Atlanta, GA 30318 (DE); TROTSENKO, Svitlana, 12107 Berlin (DE); VOGT, Anna-Maria, 12555 Berlin (DE); KASIMIR, Maria, 06110 Halle (DE)
(74) Vertreter: Maikowski & Ninnemann Patentanwälte Partnerschaft mbB
(86) Internationale Anmeldenummer: PCT/EP2011/057541
(87) Internationale Veröffentlichungsnummer: WO 2011/141471

(56) Entgegenhaltungen:
- EP-A1- 0 708 582
- WO-A2-2005/006403
- WO-A2-2008/014171
- DE-A1-102006 001 335
- DE-T2- 69 606 052
- DE-U1-202004 017 339
- US-A1- 2003 118 826
- US-A1- 2010 022 423

## Beschreibung

Die vorliegende Erfindung betrifft ein Verfahren zur Herstellung einer thermisch leitfähigen Zusammensetzung, insbesondere einer Paste, nach Anspruch 1.

Elektronische Bauteile wie Halbleiter, integrierte Schaltungen oder Transistoren sind für bestimmte Betriebstemperaturen konstruiert. Deren Betrieb generiert aber bedingt durch den Stromfluss Wärme. Die Ableitung dieser erzeugten Strahlungswärme, die durch verschiedene elektrische und elektronische Geräte wie z. B. Rechner erzeugt wird, gewinnt immer größere Bedeutung, da aufgrund der immer kleiner werdenden elektronischen Vorrichtungen und der damit verbundenen höheren elektronischen Dichte die Beseitigung der entstehenden Abwärme nach effizienteren Lösungen verlangt oder andernfalls die gebildete Wärme die Leistungsfähigkeit, Verlässlichkeit und weitere Miniaturisierung der elektronischen Vorrichtungen wesentlich beeinträchtigt.

Wärmeleitfähige Zusammensetzungen und wärmeleitfähige flächenvergrößerte Bauteile werden als Wärmeabstrahlungsmittel verwendet, damit die Wärme aus wärmeerzeugenden Teilen der elektronischen und elektrischen Geräte an die abstrahlenden Teile wie Kühlkörper oder äußere Gehäuse abgegeben werden kann. Der Kühlkörper selbst kann beispielsweise durch Konvektion oder Strahlungstechnik die aufgenommene Energie ableiten. Für die effiziente Wärmeleitung spielt die Kontaktoberfläche zwischen der Quelle und der Senke eine entscheidende Rolle. Das bedeutet, dass bei schlechtem Kontakt an den Grenzflächen der Wärmewiderstand steigt, dementsprechend sinkt die Wärmeleitfähigkeit. Wärmeleitfähige Zusammensetzungen (WLZ) dienen auch als Verbindung zwischen Wärmequelle und Wärmestrahler und verhindern die isolierenden kontaktfreien Übergänge. Die WLZ muss sich an die mikroskopischen Unregelmäßigkeiten der beiden Oberflächen anpassen, hierfür ist gutes Verteilungs- und Haftungsverhalten auf der Oberfläche von großem Vorteil.

Eine thermische Paste ist eine Mischung, umfassend ein Bindemittel in Form einer Flüssigkeit und ein thermisch leitfähiges Material z. B. in Form von Füllpartikeln. Damit die Paste eine gute Verarbeitbarkeit und Verbreitungsfähigkeit aufweist, ist das zum Einsatz kommende Bindemittel bevorzugt durch eine optimale Viskosität gekennzeichnet. Darüber hinaus darf der Anteil der festen Komponente eine bestimmte Grenze nicht überschreiten, damit die Paste als Zusammensetzung eine gute Homogenität aufweist.

Ein weit verbreitetes Bindemittel für thermische Pasten ist Polydimethylsiloxan, welches jedoch eine hohe Viskosität aufweist. Poly(ethylenglycol) (PEG) mit einem molekularen Gewicht von 400 und Natriumsilikat sind aufgrund ihrer geringeren Viskosität als Bindemittel geeigneter als Polydimethylsiloxan. Bekannte thermisch leitfähige Füllstoffe sind unter anderem Graphit, Siliziumdioxid oder Aluminium. Nachteilig ist jedoch die geringe thermische Leitfähigkeit derartiger konventioneller Zusammensetzungen, die aufgrund der schlechteren thermischen Leitfähigkeit des Bindemittels bei ungefähr 1 W/mK liegt.

Aufgrund der Verringerung der Größe und der Erhöhung der Geschwindigkeit von Halbleitervorrichtungen steigen auch die Anforderungen an die Wärmeableitung. Zur Erhöhung der Wärmeleitfähigkeit des verwendeten Grenzflächenmaterials sind verschiedene Ansätze beschrieben worden.

Ein Ansatz besteht in der Bereitstellung eines wärmeleitfähigen Mediums, welches neben einer Basiskomponente, wie zum Beispiel Polyvinylalkohol, Kohlenstoffnanoröhren oder Kohlenstoffnanofasern enthält, die über einer exzellente Wärmeleitfähigkeit verfügen (DE 10 2006 001 335 A1).

Kohlenstoffnanoröhren sind große Makromoleküle in Form von Graphitfilmen (ein hexagonales Gitter), die in Form eines Zylinders aufgerollt sind ("single-walled carbon nanotubes", SWNT). Neben den einwandigen Kohlenstoffnanoröhren sind auch Kohlenstoffnanoröhren mit mehreren Wänden bekannt ("multi-walled carbon nanotubes", MWNT), wobei letztere in Form eines Zylinders eingebracht in einem weiteren Zylinder beschrieben werden können. Kohlenstoffnanoröhren zeichnen sich durch eine hohe Festigkeit, ein geringes Gewicht, eine spezifische elektronische Struktur, eine hohe Stabilität und eine hervorragende thermische Leitfähigkeit aus. So kann die thermische Leitfähigkeit von Kohlenstoffnanoröhren bei Raumtemperatur zwischen 1800 bis 6000 W/m*k liegen (Hone et al., Synthetic metals, 1999, 103: 2498).

WO 2005/006403 A2 beschreibt die Verwendung einer thermisch leitfähigen Paste auf der Grundlage von Kohlenstoffpartikeln, wie z.B. Russpartikel, in einem geeigneten Bindemittel. Das Bindemittel kann unter anderem PEG und Zellulose umfassen.

Thermisch leitfähiges Oberflächenmaterial bestehend aus einer Matrix, einer wärmeleitfähigen Komponente z. B. Kohlenstofffasern und einem Lötmetall ist aus der WO 2008/014171 A2 bekannt. Das Matrixmaterial kann hier auf organischen Ölen, wie z. B. Pflanzenölen, oder vernetzbaren Polymeren basieren. Bevorzugte Lötmaterialien sind Indium oder seine Legierungen. Diese Zusammensetzung zeichnet sich durch eine hohe thermische Leitfähigkeit aus, die auf der Ausbildung von metallischen Bindungen mit der in Verbindung stehenden Kühlkörperoberfläche beruhen. Die Lötverbindungen wurden durch komplexe Beschichtungstechniken wie Plasmabeschichtung, "Plating", Schmelztauchen oder "Sputtering" auf die thermisch leitende Interkontaktmasse aufgebracht. Das mehrstufige Verfahren, der Einsatz der genannten Methoden sowie die Einstellung des optimalen Komponentengehaltes sind nachteilig für die technische Nutzung dieser Patente.

Die beschriebenen thermisch leitfähigen Pasten weisen jedoch verschiedene Nachteile auf. So wird in DE 10 2006 001 335 A1 als wärmeabführendes Medium eine wässrige Lösung aus Polyvinylalkohol für die Dispersion der Kohlenstoffnanoröhre eingesetzt. Das Wasser wird jedoch unter den Einsatzbedingungen langsam verdampfen, so dass die Paste ihre Konsistenz und damit ihre charakteristischen Benetzungseigenschaften verändert, was die Lebensdauer derartiger Pasten enorm einschränkt.

Die EP 0 708 582 A1 offenbart ein Pastenmaterial, das eine Mehrzahl von Metallteilchen eingebettet in eine polymere Matrix enthält. Bei der polymeren Matrix kann es sich um von pflanzlichen Ölen abgeleitete Polymere handeln.

Die US 2003/118826 A1 beschreibt eine Wärmeleitpaste, die ein pflanzliches oder tierisches Öl beinhaltet.

In der US 2010/002423 A1 wird ein Verfahren zur Herstellung einer thermisch leitfähigen Schmiere offenbart, bei dem aus Nanodiamantpulver und einer Matrix eine Dispersion hergestellt wird, bevor ein weiteres thermisches Pulver hinzugefügt und eine Mischung hergestellt wird. Bei der Matrix kann es sich beispielsweise um Olivenöl handeln.

Aus der DE 2004 017 339 U1 ist eine Wärmeleitpaste bekannt, die aus einem Füllstoff auf Basis von Graphitpulver und einem Matrixmaterial auf Basis von Öl, Fett oder Wachs besteht.

Die DE 696 06 052 T2 beschreibt ein Verfahren zur Herstellung einer Struktur mit einem Material, das ein vernetztes Polymer auf biologischer Basis beinhaltet. Nachdem ein Gemisch aus einem Polymer bestehend aus Lignin, Pflanzenöl, Baumharz, Tannin und/oder Polysaccaridharz und einem Vernetzungsmittel gebildet wurde, wird das Polymer durch das Vernetzungsmittel vernetzt.

Der Erfindung liegt das Problem zu Grunde, ein Verfahren zur Herstellung einer thermisch leitfähigen Zusammensetzung, insbesondere einer Paste, mit verbesserter Langzeitstabilität der Phasenseparation und der thermischen Ausdehnung sowie der Tieftemperaturviskosität zur Verfügung zu stellen.

Diese Aufgabe wird erfindungsgemäß durch ein Verfahren zur Herstellung einer thermisch leitfähigen Zusammensetzung mit den Merkmalen des Anspruchs 1 gelöst.

Danach umfasst das Verfahren zur Herstellung einer thermisch leitfähigen Zusammensetzung, insbesondere einer Paste, die folgenden Schritte: a) Herstellen einer Dispersion von mindestens einem thermisch leitfähigen Füllmaterial in einem polymerisierbaren Medium unter Verwendung von mindestens einem pflanzlichen und/oder tierischen Öl, und b) Polymerisation der in Schritt a) hergestellten Dispersion und c) ggf. zum Teil wiederholte mechanische Homogenisierung der Zusammensetzung.

Somit kommt es zu einer *in-situ* Einbettung des mindestens einen thermischen Füllmateriales in der sich ausbildenden Polymermatrix.

Die thermisch leitfähige Zusammensetzung bzw. Paste oder Schmiere ermöglicht einen schnellen Abtransport der Wärme von der Wärmequelle hin zum Kühlkörper, wie z.B. in einem Wärmeableiter, wobei die mikroskopische Kontaktfläche zwischen den Wärmeproduzenten und dem Kühlkörper auch bei unebenen und rauen Flächen vergrößert wird.

In einer Ausführungsform umfasst die thermisch leitfähige Zusammensetzung 0,01 bis 99,99 Gew%, bevorzugt 0,1 bis 80 Gew%, insbesondere bevorzugt 1 bis 65 Gew% des mindestens einen thermisch leitfähigen Füllmateriales, und 0,01 bis 99,99 Gew%, bevorzugt 20 bis 99,9 Gew%, insbesondere bevorzugt 35 bis 99 Gew% des mindestens einen Polymers basierend auf mindestens einem pflanzlichen und/oder tierischem Öl.

Die Wärmeleitfähigkeit der Zusammensetzung liegt bevorzugt in einem Bereich zwischen 0,1 - 10 [W/mK] und insbesondere bevorzugt 0,5 - 5 [W/mK].

In einer Ausführungsform ist das verwendete thermisch leitfähige Füllmaterial ausgewählt aus einer Gruppe enthaltend Metalle, insbesondere Silber, Kupfer, Aluminium, Metalloxide, insbesondere Kupferoxid, Kohlenstoffpartikel, insbesondere Diamant, Graphit oder Kohlenstoffnanoröhren, keramische Materialien, insbesondere Siliziumcarbid, Bornitrid oder deren Kombinationen. Der thermisch leitfähige Bestandteil kann also gleichzeitig auch eine elektrische Leitfähigkeit aufweisen. Insbesondere ist die Verwendung von mindestens zwei thermisch leitfähigen Komponenten vorgesehen.

Dabei kann die Partikelgröße der verwendeten Materialien variieren und auch unterschiedliche Größen und Formen aufweisen. So kann das thermisch leitfähige Füllmaterial als Kombination von Partikeln im Mikrometer- und Nanometer-Bereich, insbesondere kleiner 5 µm vorliegen. Auch die Form der Füllstoffe kann unterschiedlich gewählt werden, z.B. kugelsphärisch, zylindrisch, hohlzylindrisch oder stäbchenförmig. Fast alle Füllstoffe sind kommerziell über spezielle Feinchemikalienhändler wie Auer-Remy, IBUtec Advanced Materials AG, EvoChem Advanced Materials, PlasmaChem GmbH, Müller & Rössner, Bayer, FiberMax verfügbar.

In einer besonders bevorzugten Ausführungsform werden als thermisch leitfähiges Füllmaterial Kohlenstoffnanoröhren verwendet.

Als Kohlenstoffnanoröhren werden bevorzugt einwandige, doppelwandige und/oder mehrwandige Kohlenstoffnanoröhren verwendet. Die Kohlenstoffnanomaterialien können auch in Form von Nanofasern und/oder von Bündeln vorliegen. Die Kohlenstoffnanoröhren weisen insbesondere einen Durchmesser zwischen 1 bis 40 nm auf. In einer bevorzugten Ausführungsform sind die Kohlenstoffnanoröhren gleichmäßig in der Paste verteilt und stehen unter Ausbildung von Wärmestiegen miteinander in Verbindung. Durch diese Konfiguration wird die thermische Leitfähigkeit der Paste verstärkt.

Die Kohlenstoffnanoröhren können ebenfalls in modifizierter Form vorliegen. So können diese funktionalisiert z. B. auf der Oberfläche mit Carboxyl- oder mit Amino-Gruppen substituiert und/oder auf der Oberfläche oder im Inneren gefüllt z. B. mit Metall-Partikeln vorliegen.

Es ist jedoch bevorzugt, wenn bei Verwendung von Kohlenstoffnanoröhren auf die Beimischung bzw. Modifizierung der Kohlenstoffnanoröhren mit einer metallhaltigen Komponente verzichtet wird.

Gegenüber den in Patent WO 2005/006403 A2 eingesetzten Kohlenstoffpartikel weisen die formanisotropen Kohlenstoffnanoröhren mit ihrem großen Aspektverhältnis eine zirka zehnfach höhere thermische Leitfähigkeit auf. Für eine vergleichbar hohe Wärmeleitfähigkeit müsste der Gehalt von Kohlenstoffpartikeln in Pasten wie in der WO 2005/006403 A2 derart gesteigert werden, so dass dies ein Problem für die Viskosität der Pasten und deren Einsatzgebiet darstellt.

Das in der Zusammensetzung verwendete Polymer bzw. Polymermatrix, d.h. ohne Füllstoff, basiert bevorzugt auf pflanzlichen und/oder tierischen Ölen mit einer Viskosität zwischen 30 mPas und 12000 mPas, bevorzugt zwischen 40 und 1000 mPas oder 7000 und 12000 mPas, insbesondere bevorzugt zwischen 50 und 1000 mPas. Die angegebenen Viskositätswerte gelten bei Raumtemperatur, d.h. bei 25°C. Die Viskoistät der Gesamtzusammensetzung aus Polymer und Füllstoff liegt im Bereich nicht-fließfähiger Materialien.

Die Viskosität der vorliegenden Polymermatrix bzw. des Polymers ist bevorzugt so eingestellt, dass es bei höheren Temperaturen, wie bei Temperaturen über 100°C nicht zu einer Verflüssigung des Polymers bzw. Bindemittels kommt.

Die lodzahl des polymerisierten Öls kann zwischen 10 und 200, bevorzugt zwischen 70 und 120 liegen.

In einer Ausführungsform der vorliegenden Erfindung weisen die zur Polymerisation verwendeten pflanzlichen und/oder tierischen Öle mindestens eine Fettsäure mit mindestens einer Doppelbindung, insbesondere mit mindestens einer konjugierten Doppelbindung auf. Die in den verwendeten pflanzlichen und/oder tierischen Ölen vorhandenen ungesättigten Fettsäuren sind ebenfalls für die Polymerisation geeignet.

Das zum Einsatz kommende pflanzliche Öl ist bevorzugt aus einer Gruppe enthaltend Leinsamöl, Tungöl, Sojabohnenöl, Canolaöl, Sonnenblumenöl, Olivenöl, Rizinusöl, Maiskeimöl, Distelöl und Erdnussöl ausgewählt. Als tierische Öle können Öle ausgewählt aus der Gruppe enthaltend Fischöl, insbesondere Anchovisöl (Sardellenöl), Lachsöl, Pronova-Fischöl, Haifischlebertran, Störöl, Aalöl, Sardellenöl, Heringsöl (Maifischöl, Flussheringsöl) oder Rochenöl verwendet werden.

Durch die Verwendung von pflanzlichen oder tierischen Ölen wird hier auf nachwachsende Rohstoffe zugegriffen und das entstandene Polymer ist sowohl in der Verarbeitung wie hinsichtlich der Zurückgewinnung der Rohstoffe umweltfreundlich d.h. mehrheitlich biologisch abbaubar sowie für viele Anwendungen als nicht toxisch anerkannt.

Bei der Verarbeitung wird kein zusätzliches Lösungsmittel oder Polymerisationsinitiator benötigt. Die Polymerisationsreaktion kann übergangslos und ohne weitere Schritte oder Verzögerungen gestoppt werden. Somit lässt sich die Viskosität des polymeren Bindermaterials unkompliziert innerhalb weiter Bereiche von 30 mPas bis 12000 mPas, bevorzugt 40 bis 1000 mPas oder 7000 bis 12 000 mPas, insbesondere bevorzugt 50 bis 1000 mPas je nach Bedarf und in Abhängigkeit von der Füllstoffkonzentration und Zusammensetzung oder effektiven Oberfläche (Körnungsgröße) einstellen.

Bei Polymerisationen synthetischer Monomere, die im Allgemeinen mit Hilfe eines Initiators gestartet werden, kann der Polymerisationsgrad nicht an die Anforderungen angepasst werden. Ferner zeigen derartige Reaktanden häufig toxische Eigenschaften, die lange Zeit aus der Reaktionsmasse evaporieren.

Die Verwendung der pflanzlichen und tierischen Öle hat eine Reihe Vorteile gegenüber den gängig in thermisch leitenden Pasten eingesetzten Silikon-basierenden Ölen. So kommen natürliche Öle wie das Leinöl oder das chinesische Holzöl Tungöl zahlreich in der Farb- und Lackindustrie zum Einsatz. Sie werden traditionell als organische Beschichtung, als Harze oder als Rohstoff für die Harzherstellung genutzt. Hinzu kommen neben ihrem Nutzen in der Lebensmittelindustrie weitere vielseitige Anwendungen als Spezialtinte, Weichmacher, Schmiermittel, in Agrochemikalien für die Landschaft oder als Tierfuttermittel (US 3,827,993).

Weit verbreitet Einsatz finden im Allgemeinen trocknende Öle in der Industrie, welche unter Einfluss des Luftsauerstoffs zu einem harten elastischen Film polymerisieren. Seltener ist der Gebrauch der semi-trocknender Öle, welche nur teilweise unter Einfluss des Luftsauerstoffs polymerisieren und einen stabilen Film bilden.

Ein ganz wesentlicher Vorteil dieser Polymere ist ihre hervorragende Hafteigenschaft an vielen Oberflächen. Bezogen auf ihre Anwendung als Matrix in Wärmeleitpaste weisen Olivenöl und Sonnenblumenöl als Solvens für die "pristine fullerene" hervorragende Lösemittelverhalten auf.

Auch kann die Zugabe von weiteren Zusatzstoffen wie Katalysatoren, Klebrigmacher, Stabilisatoren, Antioxidanz, Verdickungsmittel, Weichmacher, Flammschutzmittel, Färbemittel und weitere Substanzen für die Qualitätsverbesserung zur thermisch leitfähigen Zusammensetzung erfolgen.

In einer Ausführungsform ist der Zusatz von mindestens einem Dispersionsmittel und/oder mindestens einem oberflächenaktiven Stoff vorgesehen, wobei das Dispersionsmittel ausgewählt ist aus der Gruppe enthaltend nicht-ionische und ionische Tenside, insbesondere Polyisobutensuccinimid.

Die Zusammensetzung wird bevorzugt als thermisches Phasengrenzflächenmaterial (interface material) verwendet.

Ein weiterer, wesentlicher Vorteil der Zusammensetzungen liegt darin, dass die temperaturabhängige Viskositätsänderung und der thermische Ausdehnungskoeffizient der pastenförmigen Zusammensetzung gering ist. Das polymerisierte Material bzw. die Polymermatrix haftet auf der Oberfläche der Füllstoffe, insbesondere der Nanofüllstoffe an. Dies minimiert die thermische Expansion und die Viskositätsmodulation der Paste. Insbesondere Kohlenstofffüllstoffe weisen ohnehin sehr geringe Wärmeausdehnungskoeffizienten von ca. 1*10⁻⁶ K⁻¹ auf.

Die Herstellung der Dispersion in Schritt a) kann zweckmäßigerweise durch UltraschallBehandlung der Probe, durch ein Kugelmahlwerk oder durch ein Walzwerk erfolgen.

Bei dem Verfahren kann auch zum Teil der Polymerisationsschritt dem Dispersionsherstellungsschritt von Füllmaterialien vorgezogen werden. So werden die thermisch leitfähigen Füllmaterialien in polymerisierte Binder oder vor-polymerisierte Öle dispergiert.

Bevorzugt wird die Polymerisation in Schritt b) bis zu einer Viskosität des polymerisierbaren Mediums zwischen 30 mPas bis 12000 mPas, bevorzugt 40 und 1000 mPas oder 7000 bis 12 000 mPas, insbesondere bevorzugt zwischen 50 bis 1000 mPas durchgeführt, wobei als polymerisierbares Medium in Schritt a) mindestens ein pflanzliches und/oder tierisches Öl verwendet wird.

Die Polymerisation in Schritt b) kann insbesondere thermisch oder mittels Strahlung, wie elektromagnetischer oder Partikelstrahlung, gestartet werden.

In einer besonders bevorzugten Ausführungsform wird die Polymerisation in Schritt b) bei einer Temperatur zwischen 50 und 550°C, bevorzugt 200 und 340°C bis zu einem Umsetzungsgrad zwischen 3 bis 100%, bevorzugt 10 bis 80% durchgeführt.

Die im Anschluss an die thermische Behandlung hergestellte polymerisierte Zusammensetzung kann danach mit geeigneten Methoden abgekühlt werden.

Das Verfahren der *in situ* Einbettung der Kohlenstoffnanoröhren in die laufende thermische Polymerisierung des Öls führt zu einer langzeitstabilen Zusammensetzung bzw. Paste. Während Pasten, die nicht auf diese Weise hergestellt sind, bereits nach einem Monat Phasentrennungen aufzeigen, wobei thermisch leitfähige Makromoleküle sich aus der Matrix absetzen, weisen *in situ* hergestellte Pasten eine hohe Stabilität auf. Diese Stabilität belegt, dass im Falle der Verwendung von Kohlenstoffnanoröhren, die *in situ* geschaffenen CNT/Polymer-Wechselwirkungen lang anhaltend sind. Die Ursache dafür, dass die einfachen Gemische aus herkömmlichen Polymer/Kohlenstoffnanoröhren keine solch vergleichbaren dauerhaften Wechselwirkungen hervorbringen, kann auf die Tatsache zurückgeführt werden, dass die großen Polymerkettenmoleküle nicht in der Lage sind, in die CNT-Aggregate hinein zu drängen. Die sterischen Effekte verhindern eine konstruktive Wechselwirkung zwischen der Polymerkette und der Oberfläche der Kohlenstoffnanoröhren.

Die Erfindung wird nachfolgend anhand mehrerer Figuren in Verbindung mit Ausführungsbeispielen näher erläutert.

Es zeigen:
- Figur 1: eine graphische Darstellung der lodzahl (Anzahl der polymerisationsaktiven Zentren) und der Viskosität einiger pflanzlicher Öle,
- Figur 2: eine schematische Darstellung der thermischen Diels-Alder Reaktion,
- Figur 3: eine graphische Darstellung zum Verlauf der Polymerisationsreaktion bei zwei unterschiedlichen Temperaturen,
- Figur 4: eine graphische Darstellung der Viskositätsänderung während der Polymerisationsreaktion bei unterschiedlichen Temperaturen,
- Figur 5: eine Aufnahme einer erfindungsgemäßen Suspension,
- Figur 6: eine graphische Darstellung des Polymerisationsverhaltens einiger natürlicher Öle,
- Figur 7: mehrere Aufnahmen von Ausführungsformen der erfindungsgemäßen Zusammensetzung,
- Figur 8: eine Aufnahme einer mit einer Polymerschicht benetzten Kohlenstoffnanoröhre,
- Figur 9: eine Aufnahme eines Teststandes zur Überprüfung der Funktionalität der hergestellten Pasten, und
- Figur 10: eine graphische Darstellung der Temperaturentwicklung im Prozessor bei einem Belastungstest,
- Figuren 11 A-D: Aufnahmen einer Paste auf der Basis von pflanzlichen Öl (A, C) und von polymerisiertem pflanzlichem Öl (B, D) zum Vergleich der Phasenseparation ("bleeding"),
- Figuren 12 A-F: Aufnahmen einer Paste auf der Basis von pflanzlichen Öl (A, B), von Silikon-Öl (C, D) und von polymerisiertem pflanzlichem Öl (E, F) bei verschiedenen Arbeitstemperaturen zum Vergleich der thermischen Ausdehnung ("pump-out"), und
- Figur 13: Aufnahmen einer Paste auf der Basis von pflanzlichen Öl (links) und von polymerisiertem pflanzlichem Öl (rechts) zum Vergleich des Verhaltens bei tiefen Temperaturen.

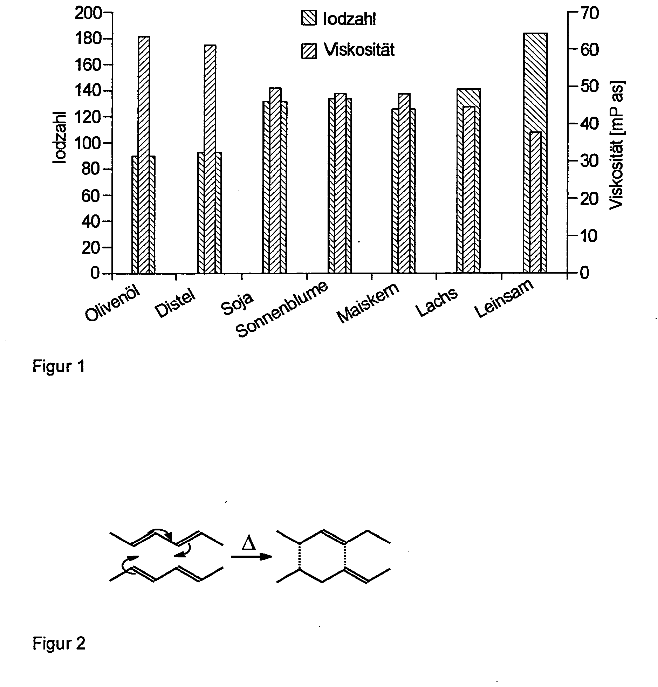

Das in Figur 1 angeführte Diagramm stellt Viskosität und die lodzahl einiger pflanzlicher und/oder tierischer Öle dar. Die Viskosität des unpolymerisierten Öls und die lodzahl bestimmen die Wahl der geeigneten Ausgangsverbindung. Auf diese Weise lässt sich in Kombination mit dem verzögerungslosen Abbruch der Polymerisationsreaktion die Viskosität des polymeren Bindermaterials unkompliziert innerhalb weiter Bereiche einstellen. Die lodzahl gibt an, wieviel Gramm lod an 100 g Fett (oder an anderen ungesättigten Verbindungen) gebunden werden können und ist damit ein Maß für den Polymerisierungsgrad.

Die in Figur 2 gezeigte Diels-Alder-Reaktion ist die bei Erwärmung bevorzugt ablaufende Reaktion, die die Polymerisation insbesondere der ungesättigten Fettsäuren in den verwendeten natürlichen Ölen bedingt. Im Verlaufe der Diels-Alder-Reaktion kommt es zur Reaktion eines Diens mit einer weiteren Doppelbindung unter Ausbildung eines Sechsringes. Da die verwendeten natürlichen Öle über eine Vielzahl von ungesättigten Fettsäuren verfügen, kann es aufgrund der Diels-Alder-Reaktion zu einer weitgehenden Vernetzung der Polymerketten kommen, wobei die Kohlenstoffnanoröhren in dieses polymere Netzwerk eingelagert werden.

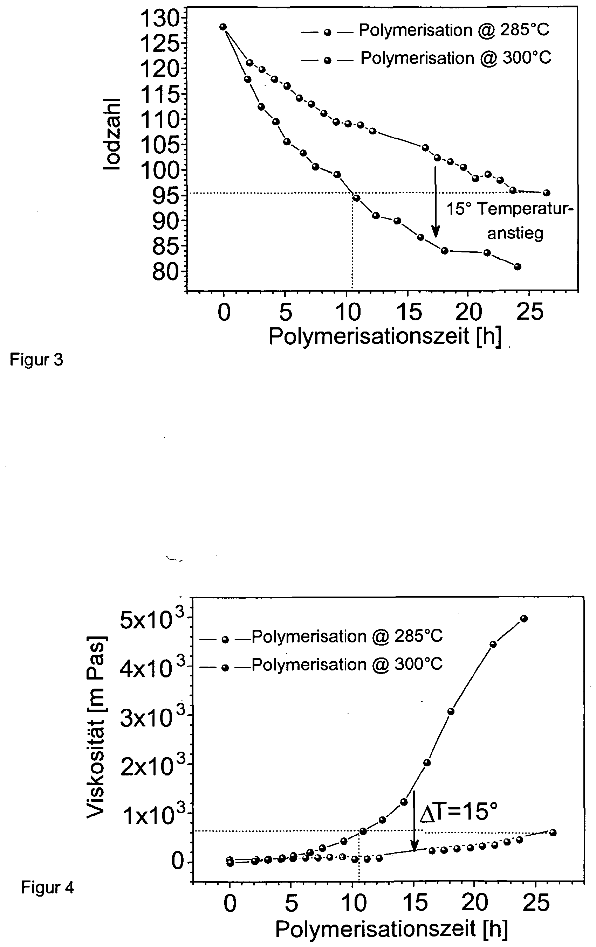

Das Diagramm in Figur 3 zeigt die Abnahme der lodzahl von Sojabohnen-Öl während der Polymerisationsreaktion bei verschiedenen Temperaturen, während im Diagramm der Figur 4 die exponentielle Zunahme der Viskosität während der Polymerisationsreaktion der Sojabohnen-Öls bei verschiedenen Temperaturen dargestellt ist.

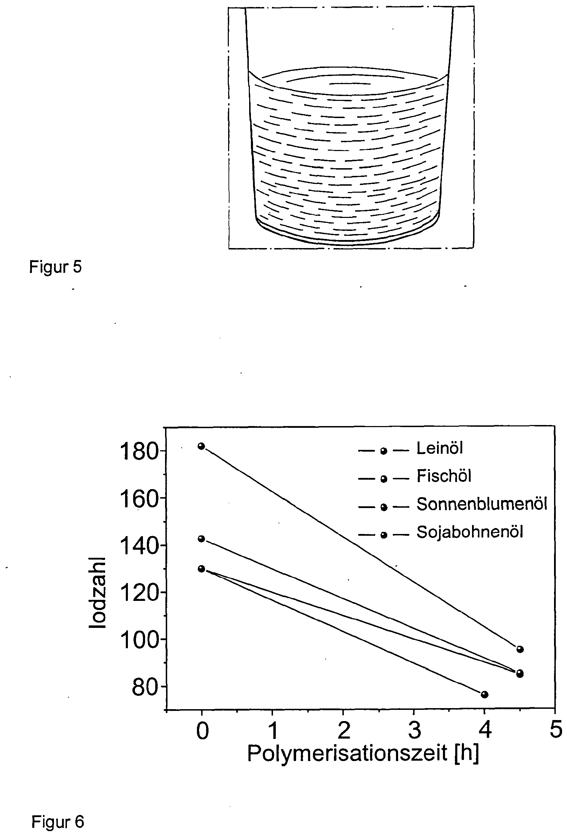

Figur 5 zeigt die Aufnahme einer Suspension aus Olivenöl mit einem Gehalt an 5 Gew. % Kohlenstoffnanoröhren.

In Figur 6 ist das Polymerisationsverhalten von verschiedenen natürlichen Ölen in Abhängigkeit von der Anzahl der polymeraktiven Zentren definiert durch die lodzahl dargestellt. So verringert sich im Verlaufe der Polymerisation die Anzahl der lodzahlen im Vergleich zu der lodzahl vor Polymerisationsbeginn. Augenscheinlich ist, das es unabhängig von der anfänglichen lodzahl der unpolymerisierten Öle zu einer Nivellierung der lodzahl der polymerisierten Öle bei Werten zwischen 80 und 70 kommt.

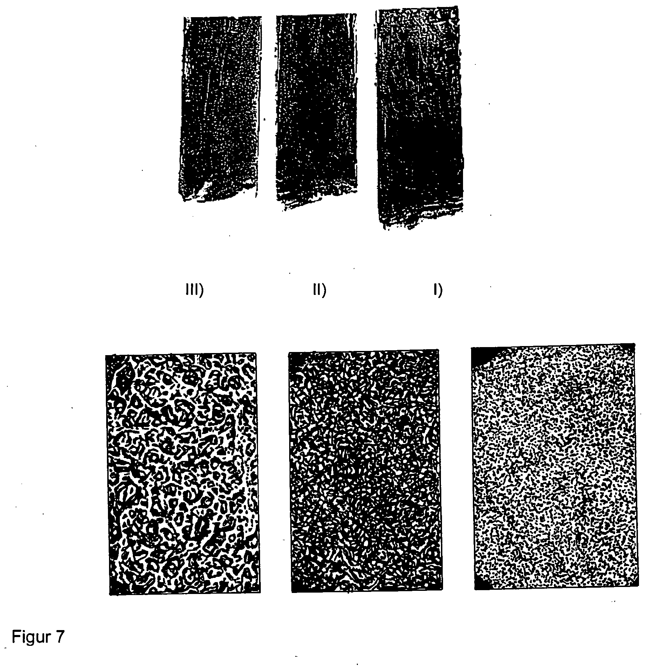

In Figur 7 sind Aufnahmen von Zusammensetzungen dargestellt, die jeweils unter modifizierten Bedingungen hergestellt wurden. So zeigt Bild I eine Zusammensetzung in Form einer Paste hergestellt durch Mischen und Homogenisieren. In Bild II ist eine Paste zu sehen, die durch *in situ* Polymerisation ohne weitere Homogenisierungsverfahren hergestellt wurde und Bild III zeigt eine Paste, die mit einem zusätzlichen Homogenisierungsschritt synthetisiert wurde. Aus den korrespondierenden mikroskopischen Abbildungen wird der Einfluss der Verfahrensschritte auf die Konsistenz des Endproduktes deutlich. Sowohl die Photoaufnahmen der Zusammensetzungen, wie die Mikroskopaufnahmen (in 50 facher Vergrößerung) belegen die unterschiedliche Verteilung und Adhäsion der Paste in Abhängigkeit vom Herstellungsverfahren. Die mikroskopischen Aufnahmen belegen deutlich den Einfluss der Polymerisation und anschließenden Homogenisierung auf die Verteilung der Kohlenstoffnanoröhren in der Paste. So bildet sich bei einem einfachen Mischen von Öl und Kohlenstoffnanoröhren (Bild I) eine inhomogene Paste mit einer sehr rauen Oberfläche (Photoaufnahme) und keinem einheitlichen Benetzungsbild der Zusammensetzung auf dem Objektträger (Mikroskopbild). Dem gegenüber stehen die Aufnahmen der homogenen Zusammensetzung mit guter Anhaftung auf der Oberfläche (Bild III), die mittels mechanischer Behandlung und durch *in situ* Polymerisation hergestellt wurde.

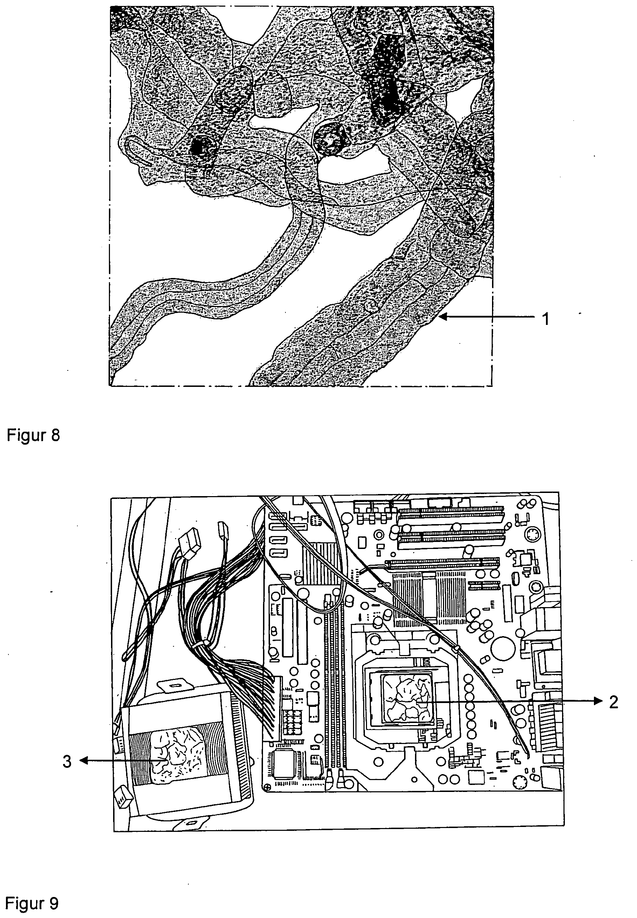

Figur 8 zeigt ein TEM-Bild einer mit einem Polymer umhüllten (benetzten) Kohlenstoffnanoröhre 1, wobei das Polymer durch Polymerisation von Fischöl hergestellt wurde.

### Ausführungsbeispiel 1:

5 g Kohlenstoffnanoröhren (BayTube C150P der Firma Bayer) werden in 20 g Fischöl (lodzahl = 143, Viskosität=40 mPa, Temperaturleitfähigkeit=0,0008 cm²/s) aufgenommen und mittels Ultraschallgerät und Walzenwerk (Dreiwalzwerk der Firma Exakt mit Spaltabständen 20µm und 8µm) zu einer homogenen Dispersion verarbeitet. Anschließend wird unter ständigem Rühren bei 295°C für ca. 6 Stunden erhitzt, wobei die lodzahl auf 80 reduziert wurde. Die entstandene Paste wird wiederholt mechanisch homogenisiert und mit dem gleichen Volumen einer 50 Gew% Fischöl/Graphit-Paste vermischt. Die Wärmeleitfähigkeit der Paste ist mit der instationär dynamischen Methode an einem HotDisk "Transient Plane Source" (TPS 2500, Hot Disc AB, Schweden) charakterisiert. Die Wärmeleitfähigkeit der Probe beträgt 1,8 W/mK.

### Ausführungsbeispiel 2:

4 g Kohlenstoffnanoröhren (Multiwall carbon nanotubes der Firma Fibermax composites) werden in 20 g Fischöl (lodzahl = 143, Viskosität = 40 mPa, Temperaturleitfähigkeit = 0,0008 cm²/s) aufgenommen und mittels Ultraschallgerät und Walzenmühle (Dreiwalzwerk der Firma Exakt mit Spaltabständen 30µm und 10pm) zu einer homogenen Dispersion verarbeitet. Anschließend wird unter ständigem Rühren bei 295°C für ca. 6 Stunden erhitzt, wobei die lodzahl auf 80 reduziert wurde. Die entstandene Paste wird wiederholt mechanisch homogenisiert und mit dem gleichen Volumen eine 40 Gew.% Fischöl/Graphit-Paste vermischt. 0,5 g Silber mit der Teilchchengröße < 5µm wird hinzugefügt. Die Paste wird anschließend geknetet und entlüftet. Die Wärmeleitfähigkeit der Paste ist mit der instationär dynamischen Methode an einem HotDisk "Transient Plane Source" (TPS 2500, Hot Disc AB, Schweden) charakterisiert. Die Wärmeleitfähigkeit der Probe beträgt 2,45 W/mK.

Die thermischen Eigenschaften der in Analogie zu den obigen Ausführungsbeisielen hergestellten Pasten werden in Tabelle 1 verglichen. Die mit TLP 1-5 bezeichneten Proben wurden durch Polymerisation von Fischöl in Gegenwart von jeweils 0,1 Gew%, 0,2 Gew%, 0,5 Gew%, 12 Gew% und 12,5 Gew% Kohlenstoffnanoröhren (BayTube C150P der Firma Bayer) hergestellt. TLP6 entspricht der Zusammensetzung des Ausführungsbeispiels 1.

Die Temperaturleitfähigkeit und die Wärmeleitfähigkeit wurden jeweils mit der Xenon-Flash-Methode (XFA 500, Linseis, Deutschland) oder dem HotDisk Verfahren (TPS 2500, Hot Disc AB, Schweden) experimentell bestimmt bzw. kalkuliert.

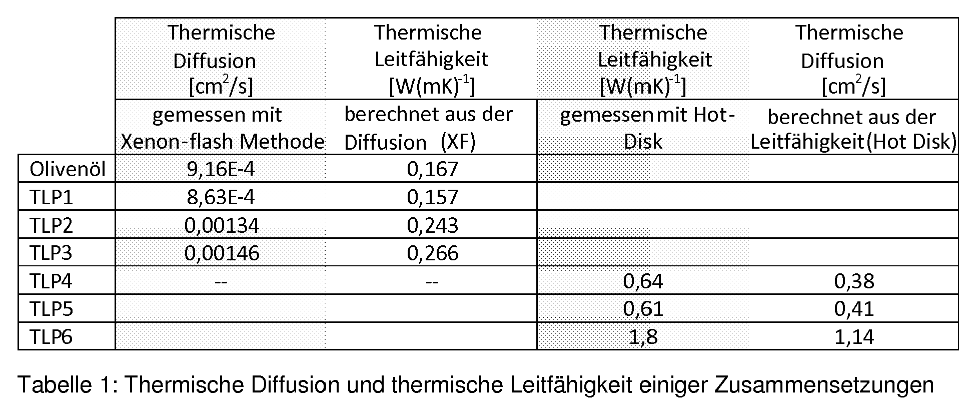

Wie aus den Werten der Tabelle 1 entnommen werden kann, führt die Erhöhung der Kohlenstoffnanoröhren-Anteil in der TLP zu Steigerung der thermischen Leitfähigkeit.

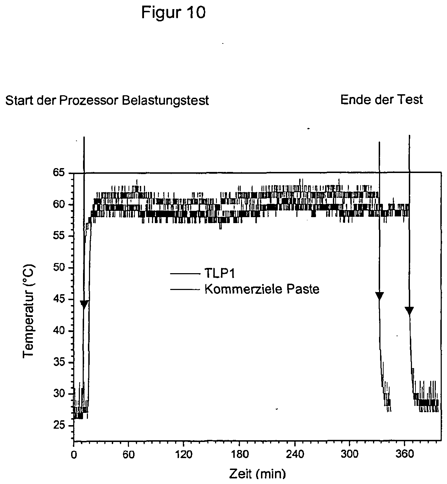

Zur Überprüfung der Funktionsweise der erfindungsgemäßen Zusammensetzungen wurden die in Tabelle aufgelisteten Pasten in einen Teststand gemäß Figur 10 eingebracht. Zu diesem Zweck wurde eine thermisch leitfähige Paste in den Zwischenraum von CPU 2 und Kühlkörper 3 aufgebracht und die Temperaturentwicklung im Prozessor beim 100%iger Belastung über die Zeit aufgetragen. Im Diagramm in Figur 10 sind die Ergebnisse der erfindungsgemäßen Zusammensetzungen gegenüber kommerziell erhältlichen Zusammensetzungen dargestellt.

Durch anhaltende komplexe Rechenaufgaben arbeitet während dieses Tests der Prozessor mit maximaler Leistung. Gleichzeitig wird die Temperaturentwicklung des Prozesses aufgezeichnet. Wie es aus der Grafik hervorgeht, liegt die Belastungstemperatur der CPU bereits für die Probe TLP 1 mit 0,1 Gew% Kohlenstoffnanoröhren niedriger als einer kommerziell erhältlichen Paste. Dieses Ergebnis demonstriert anwendungsbezogen die verbesserte thermische Leitfähigkeit der hier erfundenen Zusammensetzungen gegenüber den herkömmlich eingesetzten Pasten.

### Ausführunasbeispiel 3: Vergleich des "Bleedina"-Verhaltens

Ein zentraler Aspekt beim Einsatz der Wärmeleitpasten ist deren Langzeitstabilität hinsichtlich Phasenseparation oder "Bleeding". Bei diesem Phänomen trennt sich im Laufe der Zeit das flüssige, nieder-viskose Bindemittel der Paste vom wärmeleitfähigen, festen Füllstoff ab. Das Ausbluten ("Bleeding") wird meist durch erhöhte Arbeitstemperaturen befördert und tritt auch bei längerer Lagerung auf.

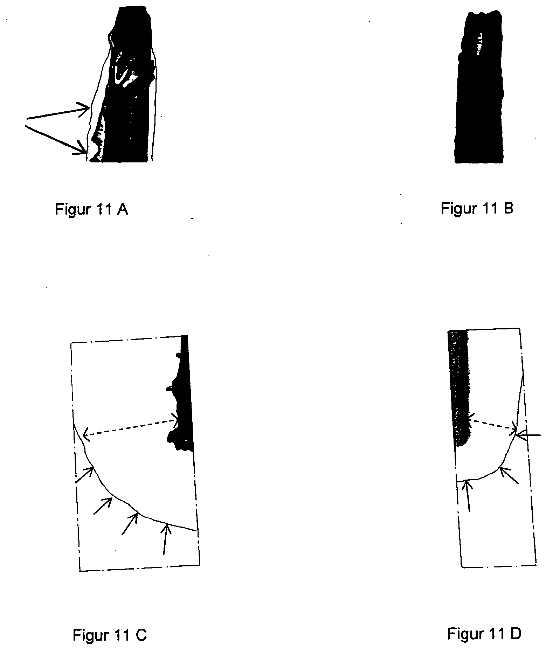

Der in den Figuren 11A bis D gezeigte Vergleichsversuch macht das Ausbluten ("Bleeding") sichtbar. Hier wurde jeweils eine herkömmliche Paste auf Basis pflanzlichen Öls, also unpolymerisiert (Figur 11 A), und eine Paste auf Basis der vorliegenden Erfindung beschriebene polymerisierten pflanzlichen Öls (Figur 11 B) auf einem Absorbermaterial ("Chromatographie-Papier") aufgetragen. Wie in Figur 11A zu sehen läuft das flüssige Schmiermittel aus der herkömmlichen Paste aus und zeigt einen Schatten am linken Rand der Bahn. Der Schatten deutet darauf hin, dass das Chromatographie-Papier durchfeuchtet ist, während die erfindungsgemäße Probe (Figur 11 b) kaum ausläuft und die Unterlage nicht durchnässt.

Wird die Versuchstemperatur auf 50°C erhöht - was bei dem Einsatz der Pasten als eine niedrige Betriebstemperatur gilt -, zeichnet sich der Unterschied der beiden Pasten noch deutlicher ab. So ist in Figur 11C eine deutlich längere Laufstrecke des Bindematerials (〈̶---〉̶) zu erkennen, während diese Laufstrecke im Falle der erfindungsgemäßen Paste sehr kurz ist. Somit unterliegt die erfindungsgemäße Paste auch bei längerer Lagerung bei erhöhten Temperaturen einer wesentlich geringeren Phasentrennung und ist somit gegenüber einer herkömmlichen Paste, die lediglich aus nicht-polymerisierten Ölen hergestellt wird, durch eine höhere Stabilität gekennzeichnet.

### Ausführunasbeispiel 4: Vergleich der thermischen Ausdehnung ("pump-out")

Ein weiterer wichtiger Aspekt beim Einsatz der Wärmeleitpasten ist deren Langzeitstabilität hinsichtlich thermischer Ausdehnung oder "pump-out". Hierzu kommt es, wenn sich im Einsatz bei erhöhter Temperatur die Paste aufgrund der thermischen Ausdehnung (Expansion) und aufgrund der Verflüssigung des Bindemittels aus der Einsatzspalte herausdrückt. Die so entstandenen Hohlräume blockieren den Wärmetransfer.

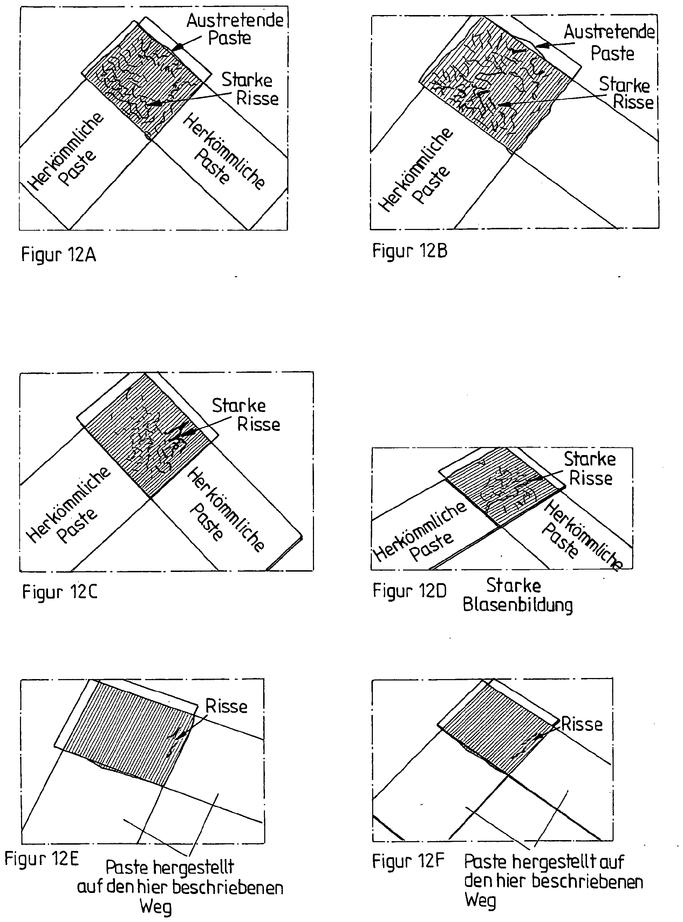

Der in den Figuren 12A bis 12F gezeigte Vergleichsversuch macht das "pump-out" sichtbar. Eine ausreichend dünne Schicht von Wärmeleitpaste basierend auf einem pflanzlichen, nicht-polymerisierten Öl (Figur 12A, B), basierend auf Silikonöl (Figur 12C, D) und basierend auf dem erfindungsgemäß polymerisierten Öl (Figur 12E, F) wurden auf jeweils eine Aluminiumplatte aufgetragen und mit einer Glasplatte verdeckt.

Die beiden Platten wurden aufeinander fixiert und anschließend für die Dauer von 165 Stunden auf 100 (Figuren 12A, C, E) bzw. 150 °C (Figuren 12B, D, F) temperiert. Anschließend wurde der Zustand der Wärmeleitpaste hinsichtlich des "pump-out"-Verhaltens untersucht und analysiert.

Die herkömmliche Paste unter Verwendung von nicht-polymerisiertem Pflanzenöl zeigt sowohl bei 100°C als auch bei 150°C starke Risse auf. Auch kommt es bei den genannten Temperaturen zu einem Austreten bzw. Auslaufen der Paste (Figuren 12A, B). Auch im Falle der Silikonöl-basierten Paste (Figuren 12C, D) treten verstärkt Risse und bei 150°C sogar Blasen auf. Aus dem Vergleich geht klar der Vorzug der erfindungsgemäßen Paste (Figuren 12E, F) hervor, die gut an am Auftragungsort anhaften bleibt und sogar nach dem Test bei 150 °C eine fast intakte und lückenlose Fläche aufweist.

### Ausführunasbeispiel 5: Vergleich der Tieftemperatur-Verhalten (Kristallisation)

Eine weitere wichtige Eigenschaft der Wärmeleitpaste, die ihren Einsatz mit beeinflusst, ist die Tieftemperatur-Viskosität. Die Einsatztemperatur von Pasten ist stets größer als 50°C. Dennoch sind Vorrichtungen mit Wärmeleitpasten zwischen mehreren Einsätze zum Teil extremen Tieftemperaturen ausgesetzt (zum Beispiel in Stromwechselvorrichtungen bei Windgeneratoren). Daher ist es von großer Bedeutung, Pasten mit geringer Tieftemperaturviskosität zu haben.

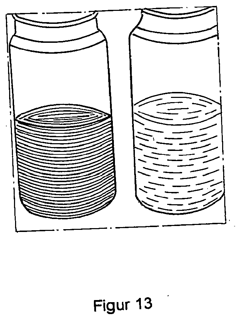

Der Vergleich von Matrices basierend auf unpolymerisierten pflanzlichen Ölen (Figur 13, links) mit denjenigen auf Basis von polymerisierten Ölen gemäß der vorliegenden Erfinidng (Figur 13, rechts) stellt einem weiteren Vorzug der hier vorgestellten polymerisierten Öle dar. Probe (a) ist bei -80 °C nicht mehr transparent, da sie bereits amorph kristallisiert. Bei der Probe (b) nimmt die Viskosität zu, es kommt jedoch nicht zu einer Kristallisation.

Während die pflanzlichen Öle bereits bei Temperaturen unterhalb 0°C auskristallisieren und erstarren (Figur 13, links), bleiben die polymerisierten Öle bis weit in den zweistelligen Minus-Temperatur-Bereich hin klar (Figur 13, rechts).

## Patentansprüche

1. Verfahren zur Herstellung einer thermisch leitfähigen Zusammensetzung, insbesondere einer Paste, umfassend die folgenden Schritte:
a) Herstellen einer Dispersion von mindestens einem thermisch leitfähigen Füllmaterial in mindestens einem polymerisierbaren Medium unter Verwendung von mindestens einem pflanzlichen und/oder tierischen Öl, und
b) Polymerisation der in Schritt a) hergestellten Dispersion.

2. Verfahren nach Anspruch 1, **dadurch gekennzeichnet, dass** die Polymerisation in Schritt b) bis zu einer Viskosität des polymerisierbaren Mediums zwischen 30 mPas und 12000 mPas, bevorzugt 40 und 1000 mPas oder 7000 bis 12 000 mPas, insbesondere bevorzugt zwischen 50 bis 1000 mPas durchgeführt wird, wobei als polymerisierbares Medium in Schritt a) mindestens ein pflanzliches und/oder tierisches Öl verwendet wird.

3. Verfahren nach einem der Ansprüche 1 oder 2, **dadurch gekennzeichnet, dass** die Polymerisation in Schritt b) thermisch und/oder mittels Strahlung gestartet wird.

4. Verfahren nach einem der vorhergehenden Ansprüche, **dadurch gekennzeichnet, dass** die Polymerisation in Schritt b) bei einer Temperatur zwischen 50 und 550°C, bevorzugt 200 und 340°C bis zu einem Umsetzungsgrad zwischen 3 bis 100%, bevorzugt 10 bis 80% durchgeführt wird.

5. Verfahren nach einem der vorhergehenden Ansprüche, **dadurch gekennzeichnet, dass** 0,01 bis 99,99 Gew%, bevorzugt 0,1 bis 80 Gew%, insbesondere bevorzugt 1 bis 65 Gew% des mindestens eines thermisch leitfähigen Füllmateriales, und 0,01 bis 99,99 Gew%, bevorzugt 20 bis 99,9 Gew%, insbesondere bevorzugt 35 bis 99 Gew% des mindestens einen polymerisierbaren Mediums basierend auf mindestens einem pflanzlichen und/oder tierischem Öl verwendet werden.

6. Verfahren nach einem der vorhergehenden Ansprüche, **dadurch gekennzeichnet, dass** das thermisch leitfähige Füllmaterial ausgewählt ist aus einer Gruppe enthaltend Metalle, Metalloxide, Kohlenstoffpartikel, insbesondere Diamant, Graphit oder Kohlenstoffnanoröhren, keramische Materialien, insbesondere Siliziumcarbid, Bornitrid oder deren Kombinationen.

7. Verfahren nach einem der vorhergehenden Ansprüche, **dadurch gekennzeichnet, dass** als thermisch leitfähiges Füllmaterial Kohlenstoffnanoröhren verwendet werden.

8. Verfahren nach Anspruch 7, **dadurch gekennzeichnet, dass** einwandige oder mehrwandige Kohlenstoffnanoröhren verwendet werden.

9. Verfahren nach einem der vorhergehenden Ansprüche, **dadurch gekennzeichnet, dass** als thermisch leitfähiges Füllmaterial funktionalisierte Kohlenstoffnanoröhren, insbesondere mit Carboxyl- oder mit Aminogruppen funktionalisierte Kohlenstoffnanoröhren verwendet werden.

10. Verfahren nach einem der vorhergehenden Ansprüche, **dadurch gekennzeichnet, dass** als polymerisierbares Medium pflanzliche und/oder tierische Öle verwendet werden, die mindestens eine Fettsäure mit mindestens einer Doppelbindung, insbesondere mit mindestens einer konjugierten Doppelbindung aufweisen.

11. Verfahren nach einem der vorhergehenden Ansprüche, **dadurch gekennzeichnet, dass** das pflanzliche Öl ausgewählt ist aus der Gruppe enthaltend Leinsamöl, Tungöl, Sojabohnenöl, Canolaöl, Sonnenblumenöl, Olivenöl, Rizinusöl, Erdnussöl, Maiskeimöl, Distelöl oder deren Mischungen.

12. Verfahren nach einem der vorhergehenden Ansprüche, **dadurch gekennzeichnet, dass** das tierische Öl ausgewählt ist aus der Gruppe enthaltend Fischöl, insbesondere Anchovisöl (Sardellenöl), Lachsöl, Pronova-Fischöl, Haifischlebertran, Störöl, Aalöl, Sardellenöl, Heringsöl (Maifischöl, Flussheringsöl) oder Rochenöl.

13. Verfahren nach einem der vorhergehenden Ansprüche, **dadurch gekennzeichnet, dass** mindestens ein Dispersionsmittel und/oder mindestens ein oberflächenaktiver Stoff ausgewählt aus der Gruppe enthaltend nicht-ionische und ionische Tenside, insbesondere Polyisobutensuccinimid, verwendet wird.

14. Verfahren nach einem der vorhergehenden Ansprüche, **dadurch gekennzeichnet, dass** die lodzahl des polymerisierten Öles zwischen 10 und 200, bevorzugt zwischen 70 und 120 liegt.

15. Verfahren nach einem der vorhergehenden Ansprüche, **dadurch gekennzeichnet, dass** eine *in-situ* Einbettung des mindestens einen thermischen Füllmaterials in der sich ausbildenden Polymermatrix erfolgt.

## Claims

1. Process for producing a thermally conductive composition, in particular a paste, comprising the following steps:
a) providing a dispersion of at least one thermally conductive filler material in at least one polymerizable medium using at least one vegetable and/or animal oil, and
b) Polymerization of the dispersion obtained in step a).

2. Process according to claim 1, **characterized in that** the polymerization in step b) is carried out until a viscosity of the polymerizable medium between 30 mPas and 12 000 mPas, preferably 40 and 1000 mPas or 7000 till 12 000 mPas, in particular preferably between 50 to 1000 mPas is obtained, wherein at least one vegetable and/or animal oil is used as polymerizable medium in step a).

3. Process according to one of the claims 1 or 2, **characterized in that** the polymerization in step b) is started thermally and/or by radiation.

4. Process according to one of the preceding claims, **characterized in that** the polymerization in step b) is carried out at a temperature between 50 and 550°C, preferably 200 and 340°C until a conversion level between 3 to 100%, preferably 10 to 80% is reached.

5. Process according to one of the preceding claims, **characterized in that** 0.01 to 99.99 weight%, preferably 0.1 to 80 weight%, in particular preferably 1 to 65 weight% of the at least one thermally conductive filler material and 0.01 to 99.99 weight%, preferably 20 to 99.9 weight%, in particular preferably 35 to 99 weight% of the at least one polymerizable medium based on at least one vegetable and/or animal oil is used.

6. Method according to one of the preceding claims, **characterized in that** the thermally conductive filler material is selected from a group containing metals, metal oxides, carbon particles, in particular diamond, graphite or carbon nanotubes, ceramic materials, in particular silicium carbide, bor nitrite or a combination thereof.

7. Process according to one of the preceding claims, **characterized in that** carbon nanotubes are used as thermally conductive filler material.

8. Process according to claim 7, **characterized in that** single-walled or multi-walled carbon nanotubes are used.

9. Process according to one of the preceding claims, **characterized in that** functionalized carbon nanotubes, in particular carbon nanotubes functionalized with carboxyl or amino groups are used as thermally conductive filler material.

10. Process according to one of the preceding claims, **characterized in that** vegetable and/or animal oils are used as polymerizable medium which contain at least one fatty acid with at least one double bound, in particular with at least one conjugated double bound.

11. Method according to one of the preceding claims, **characterized in that** the vegetable oil is selected from a group containing linseed oil, Tung oil, soybean oil, Canola oil, sunflower oil, olive oil, castor oil, peanut oil, corn oil, safflower oil or mixtures thereof.

12. Process according to one of the preceding claims, **characterized in that** the animal oil is selected from a group containing fish oil, in particular anchovy oil (anchovy oil), Pronova fish oil, shark cod liver oil, sturgeon oil, eel oil, anchovy oil, herring oil (shad oil, river herring oil) or ray oil.

13. Method according to one of the preceding claims, **characterized in that** at least one dispersion means and/or at least one surface active compound selected from the group containing non-ionic and ionic tensides, in particular polyisobutensuccinimid, are used.

14. Process according to one of the preceding claims, **characterized in that** the iodine number of the polymerized oil is between 10 and 200, preferably between 70 and 120.

15. Process according to one of the preceding claims, **characterized in that** an in-situ embedding of the at least one thermally conductive filler material occurs in the forming polymer matrix.

## Revendications

1. Procédé de fabrication d'une composition thermoconductrice, en particulier une pâte, comprenant les étapes suivantes :
a) la préparation d'une dispersion d'au moins une charge thermoconductrice dans au moins un milieu polymérisable en utilisant au moins une huile végétale et/ou animale, et
b) la polymérisation de la dispersion préparée lors de l'étape a).

2. Procédé selon la revendication 1, **caractérisé en ce que** la polymérisation est effectuée à l'étape b) jusqu'à une viscosité du milieu polymérisable comprise entre 30 mPas et 12 000 mPas, de manière préférée 40 et 1 000 mPas ou de 7 000 à 12 000 mPas, de manière particulièrement préférée entre 50 et 1 000 mPas, dans lequel au moins une huile végétale et/ou animale est utilisée en tant qu'agent polymérisable à l'étape a).

3. Procédé selon l'une des revendications 1 ou 2, **caractérisé en ce que** la polymérisation est débutée à l'étape b) de manière thermique et/ou au moyen d'un rayonnement.

4. Procédé selon l'une des revendications précédentes, **caractérisé en ce que** la polymérisation est effectuée à l'étape b) à une température comprise entre 50 et 550 °C, de manière préférée 200 et 340 °C jusqu'à un taux de conversion compris entre 3 et 100 %, de manière préférée 10 et 80 %.

5. Procédé selon l'une des revendications précédentes, **caractérisé en ce que** sont utilisés de 0,01 à 99,99 % en poids, de manière préférée de 0,1 à 80 % en poids, de manière particulièrement préférée de 1 à 65 % en poids de la au moins une charge thermoconductrice et de 0,01 à 99,99 % en poids, de manière préférée de 20 à 99,9 %, de manière particulièrement préférée de 35 à 99 % en poids du au moins un milieu polymérisable à base d'au moins une huile végétale et/ou animale.

6. Procédé selon l'une des revendications précédentes, **caractérisé en ce que** la charge thermoconductrice est choisie dans un groupe contenant des métaux, des oxydes métalliques, des particules de carbone, en particulier du diamant, du graphite ou des nanotubes de carbone, des matériaux céramiques, en particulier du carbure de silicium, du nitrure de bore ou leurs combinaisons.

7. Procédé selon l'une des revendications précédentes, **caractérisé en ce que** sont utilisés en tant que charge thermoconductrice des nanotubes de carbone.

8. Procédé selon la revendication 7, **caractérisé en ce que** des nanotubes de carbone à une paroi ou à plusieurs parois sont utilisés.

9. Procédé selon l'une des revendications précédentes, **caractérisé en ce que** sont utilisés, en tant que charge thermoconductrice, des nanotubes de carbone fonctionnalisés, en particulier des nanotubes de carbone fonctionnalisés avec des groupes carboxyle ou avec des groupes amino.

10. Procédé selon l'une des revendications précédentes, **caractérisé en ce que** sont utilisées en tant que milieu polymérisable des huiles végétales et/ou animales, qui présentent au moins un acide gras avec au moins une double liaison, en particulier avec au moins une double liaison conjuguée.

11. Procédé selon l'une des revendications précédentes, **caractérisé en ce que** l'huile végétale est choisie dans le groupe contenant l'huile de lin, l'huile d'abrasin, l'huile de soja, l'huile de canola, l'huile de tournesol, l'huile l'olive, l'huile de ricin, l'huile d'arachide, l'huile de maïs, l'huile de carthame ou leurs mélanges.

12. Procédé selon l'une des revendications précédentes, **caractérisé en ce que** l'huile animale est choisie parmi le groupe contenant l'huile de poisson, en particulier l'huile d'anchois (huile d'anchois commun), huile de saumon, l'huile de poisson de Pronova, huile de foie de requin, l'huile d'esturgeon, l'huile d'anguille, l'huile d'anchois commun, l'huile de hareng (huile d'alose, huile de gaspareau) ou l'huile de raie.

13. Procédé selon l'une des revendications précédentes, **caractérisé en ce que** sont utilisés au moins un agent de dispersion et/ou au moins une substance tensioactive choisis dans le groupe contenant des agents tensioactifs non ioniques et ioniques, en particulier du polyisobutène succinimide.

14. Procédé selon l'une des revendications précédentes, **caractérisé en ce que** l'indice d'iode de l'huile polymérisée se situe entre 10 et 200, de manière préférée entre 70 et 120.

15. Procédé selon l'une des revendications précédentes, **caractérisé en ce qu'**une incorporation *in situ* de la au moins une charge thermique a lieu dans la matrice de polymère en cours de formation.
